Europäisches Patentamt

European Patent Office

Office européen des brevets

(11) Veröffentlichungsnummer: **0 632 298 A2**

(12) **EUROPÄISCHE PATENTANMELDUNG**

(21) Anmeldenummer: **94109163.9**

(22) Anmeldetag: **15.06.94**

(51) Int. Cl.⁶: **G02B 6/12, H01S 3/085**

(30) Priorität: **03.07.93 DE 4322163**

(43) Veröffentlichungstag der Anmeldung:
**04.01.95 Patentblatt 95/01**

(84) Benannte Vertragsstaaten:
**DE ES FR GB IT NL**

(71) Anmelder: **ANT Nachrichtentechnik GmbH**
**Gerberstrasse 33**
**D-71522 Backnang (DE)**

(72) Erfinder: **Hillmer, Hartmut, Dr.**
**Peter-Behrens-Strasse 12**
**D-64287 Darmstadt (DE)**

(54) **DFB- oder DBR-Gitter.**

㊗ 2.1. Die Erfindung dient der Optimierung der Kenngrößen von auf DFB-oder DBR-Gittern basierenden optoelektronischen Bauelementen.

2.2. Erfindungsgemäß liegt lateral zentral ein Gitterbereich, an den lateral zwei gitterfreie Bereiche angrenzen, wobei die Gitterbegrenzungen, insbesondere in der Nähe des Intensitätsmaximums des geführten Lichtfeldes, in Form von kontinuierlich verlaufenden Krümmungen ausgebildet sind. Dabei wird durch die gezielte Ausbildung der Gitterbereiche und der gitterfreien Bereiche die laterale Wellenführung erheblich unterstützt.

2.3. Die erfindungsgemäße Lösung läßt sich insbesondere vorteilhaft bei optoelektronischen Bauelementen, wie Lasern, Laserverstärkern, Filtern, Kopplern und Schaltern einsetzen.

EP 0 632 298 A2

Die Erfindung dient der Optimierung der Kenngrößen von auf DFB- oder DBR-Gitter basierenden optoelektronischen Bauelementen, wie beispielsweise Lasern, Laserverstärkern, Filtern, Kopplern und Schaltern.

Bekannt ist die Erzeugung von Phasenverschiebungen über die axiale Verlängerung einer einzigen oder einer kleinen Zahl von Gitterperioden.

Abhängig von der Höhe der Kopplungskoeffizienten erzeugt eine abrupte Phasenverschiebung in DFB-Gittern verschieden starke Photonenzahl-Überhöhungen am Ort der Phasenverschiebung/en, welche manche Eigenschaften optoelektronischer Komponenten negativ beeinflussen können. Realisiert werden können abrupte Phasenverschiebungen durch holographische Verfahren [z.B. T. Numai et al, Jap. J. Appl. Phys. 26, L 1910 (1987)] oder mittels Elektronenstrahl-Lithographie (EL).

Die starke Photonenzahl-Überhöhung am Ort, z. B. einer λ/4 Phasenverschiebung, kann durch das Aufteilen des gesamten Phasenverschiebungs-Betrags auf mehrere örtlich voneinander getrennte Phasenverschiebungs-Anteile ( multiple phaseshifts) etwas abgeschwächt werden [z.B. S. Ogita et al. J. Ligthwave Technol 8, 1596 (1990)]. Die einzelnen Teil-Phasenverschiebungen wurden jedoch auch hierbei mittels Elektronenstrahl-Lithographie oder holographischer Methoden abrupt ausgeführt.

Desweiteren sind Lösungen bekannt, bei denen die Erzeugung von Phasenverschiebungen über die axiale Variation des effektiven Brechungsindex erfolgt.

So werden Phasenverschiebungen beispielsweise auch über eine laterale Aufweitung oder Verengung der Streifenbreite der aktiven Zone bzw. der aktiven Zone und benachbarter Schichten über eine bestimmte Länge der longitudinalen Bauelementelänge realisiert [z.B. H. Soda et al., IEEE J. Quant. electron. QE-23, 804 (1987), oder G. Chen et al. Appl. Phys. Lett 60, 2586 (1992)]. Dabei wurde der effektive Brechungsindex in longitudinaler Richtung quasi abrupt geändert. Dies führt zu unerwünschten zusatzlichen optischen Vielfachreflektionen und optischen Interferenzeffekten an den Stellen, an denen sich der Brechungsindex abrupt ändert. Ferner wurden die Vorteile, welche eine beliebig auf einen längeren Teilabschnitt verteilte kontinuierliche Phasenverschiebung bietet, bei weitem nicht ausgeschöpft.

Eine weitere bekannte Lösung beinhaltet eine mit der z-Richtung lineare Änderung der lateralen Streifenbreite der aktiven Schicht und benachbarter Schichten über einen longitudinalen Teilabschnitt des Bauelements, um die Phasenverschiebung örtlich zu verteilen [z.B. Y. Nakano et al., IEEE J. Q. Electron. 24, 2017 (1988), oder J. Kinoshita et al. IEEE J. Q. Electron. 27, 1759 (1991)]. Nicht alle Vorteile, welche eine beliebige, kontinuierliche Verteilung der Phasenverschiebung bietet, wurden genutzt.

Bekannt ist weiterhin die sinusförmige Brechungsindex-Variation mittels in axialer Richtuing variierter Streifenbreite. Diese Lösung wurde theoretisch vorgeschlagen, um eine vollständige Einmodigkeit zu erreichen [K. Tada et al. Electron. Lett. 20, 82 (1984)].

Desweiteren ist eine Lösung zur Erzeugung von Phasenverschiebungen bekannt, die auf einer Aufweitung der vertikalen Dicke der aktiven Schicht oder benachbarter Wellenleiterschichten über eine bestimmte Länge der longitudinalen Bauelementelänge beruht [z.B. B. Broberg, et al. Appl. Phys. Lett. 47, 4 (1985) oder K. Kojima et al. J. Lightwave Technol. LT-3, 1048 (1985)]. Dies führt zu unerwünschten zusätzlichen optischen Vielfachreflektionen und optischen Interferenzeffekten an den Stellen, an denen sich der Brechungsindex abrupt ändert. Ferner wurden die Vorteile, welche eine beliebig auf einen längeren Teilabschnitt verteilte kontinuierliche Phasenverschiebung ermöglicht, bei weitem nicht ausgeschöpft.

Weitere bekannte Lösungen beinhalten die Erzeugung einer Phasenverschiebung über die axiale Variation der Gitterperiode.

In der Literatur sind Beispiele für die abrupte Änderungen der Gitterperiode in axialer Bauelementerichtung angeführt. In der zentral gelegenen Sektion des Laser Resonators wurde holographisch eine größere Gitterperiode realisiert als in den Seitensektionen. Diese Struktur konnte erfolgreich zur Reduktion der optischen Linienbreite genutzt werden [M. Okai et al., IEEE J. Quantum Electron 27, 1767 (1991)]. Der mittlere Bereich geänderter Gitterperiode dient der Erzeugung der Phasenverschiebung. Es wurden mit dieser Struktur abrupte Gitterperioden-Änderungen erzeugt. Es wurden jedoch nicht alle Vorteile, welche eine kontinuierliche Variation des Kopplungskoeffizienten bietet, ausgeschöpft.

In gewissem Rahmen ermöglicht auch EL die Realisierung von im Ortsraum verteilten Phasenverschiebungen über die Änderung der Gitterperiode in longitudinaler Richtung. Allerdings ist bei diesem Verfahren die Differenz zwischen benachbarten Gitterperioden auf größere Werte begrenzt. Dadurch können mit EL lediglich DFB-Gitter hergestellt werden, welche eine kleine Anzahl verschiedener Sektionen aufweisen, innerhalb denen die Gitterperiode konstant ist, sich jedoch von Sektion zu Sektion unterscheidet. Es können keine quasikontinuierlichen Variationen der Gitterperiode mit dem Ort erreicht werden. Ferner ist EL ein kompliziertes Verfahren und die EL-Schreibzeit ist sehr teuer.

Gekrümmte Wellenleiter auf homogenen DFB- oder DBR-Gitterfeldern können, wie bereits bekannt, zur Definition von Gittern mit axial variierter Gitterperiode genutzt werden. Mit dieser Methode können auch

2

definierte Phasenverschiebungen über eine gezielte axiale Variation der Gitterperiode erzeugt werden und gleichzeitig die Phasenverschiebungen axial beliebig und quasikontinuierlich verteilt werden.

Eine weitere Gruppe von bekannten Lösungen beinhaltet die Erzeugung einer Variation des Kopplungskoeffizienten in axialer Richtung.

So wurde beispielsweise eine abrupte Änderung des Kopplungskoeffizienten in longitudinaler Richtung des Bauelements durch partielle Photolack-Remaskierung nach einer Teiltrockenätzung des DFB-Gitters erreicht [z.B. M. Matsuda et al., Conference on InP and related compounds (1991)].

Eine kontinuierliche axiale Variation des Kopplungskoeffizienten K wurde durch eine Doppelbelichtung einer auf einer Wafer-Oberfläche aufgetragenen Photolackschicht erreicht. Der Photolack enthält nach der Doppel-Belichtung die Information zweier sich überlagernder und sich durchdringender homogener DFB-Gitter, welche sich in ihrer Gitterperiode allerdings um $\Delta\Lambda$ unterscheiden. [A. Talneau et al., Electron. Lett. 28, 1395 (1992)]. Dieses Verfahren ermöglicht abhängig von der Wahl von $\Delta\Lambda$ jeweils nur eine vollständig definierte Funktion K(z) sowie genau eine dazu korrespondierende Bauelementelänge L, wenn die Periodizität der Struktur in Hinblick auf hohe Bauelementausbeute genutzt wird. Die Vorteile, welche eine beliebige Änderung von K(z) bietet, können mit diesem Verfahren nicht genutzt werden.

Die erfindungsgemäße Lösung dient der Optimierung der Kenngrößen des optoelektronischen Bauelements unter Vermeidung der beschriebenen Nachteile der bekannten Lösungen. Die erfindungsgemäße Lösung betrifft optoelektronische Bauelemente, welche eine derart periodisch strukturierte Grenzfläche zwischen zwei Halbleiter-Schichten enthalten, daß eine optische Rückkopplung des geführten Lichtes entsteht (DFB- oder DBR-Gitter; DFB = distributed feedback, DBR = distributed Bragg reflector). Wichtigstes Merkmal der Struktur ist das besonders angeordnete DFB- oder DBR-Gitter, wobei die verteilte Rückkopplung durch ein in longitudinaler Richtung periodisches, geätztes Materialgitter realisiert wird, so daß eine periodische Variation des Real- und/oder Imaginärteils des Brechungsindex erreicht wird. Der Kern des optoelektronischen Bauelements besteht hierbei aus mindestens drei verschiedenen Halbleiter-Schichtpaketen, die in vertikaler Richtung (y-Richtung) auf dem Halbleitersubstrat übereinander aufgebracht sind. Jedes dieser Halbleiter-Schichtpakete ist in y-Richtung nicht notwendigerweise homogen, sondern kann auch seinerseits wieder aus verschiedenen Einzelschichten oder aus kontinuierlichen Übergängen zwischen verschiedenen Halbleiter-Schichten aufgebaut sein. Jedes Halbleiter-Schichtpaket wird daher im folgenden vereinfachend auch als Quasi-Einzelschicht benannt, d. h. mit dem Begriff "Halbleiter-Schicht" bezeichnet. Die zweite Halbleiter-Schicht enthält bei dieser Ausführungsform die laseraktive/n Halbleiter-Schicht/en, d. h. die Halbleiter-Schicht/en mit dem höchsten Brechungsindex.

Die Bezeichnung Halbleiter-Schicht beinhaltet im Falle der laseraktiven zweiten Halbleiter-Schicht z.B. auch eine Anzahl von Potentialtöpfen (quantum wells) und eine dementsprechende Anzahl von Potentialbarrieren. Im folgenden ist unter dem Brechungsindex einer Halbleiter-Schicht der innerhalb dieses Halbleiter-Schichtpakets gemittelte Brechungsindex zu verstehen. Unterhalb der ersten Halbleiter-Schicht ist das Halbleitersubstrat angeordnet. Das vertikale Dotierungsprofil der Struktur ist nach bekannten Halbleiterlaser-Design-Prinzipien ausgestaltet, so daß sich der pn-Übergang in der Nähe oder in der aktiven zweiten Halbleiter-Schicht befindet. Dabei ist sowohl n-leitendes als auch p-leitendes Halbleitersubstrat anwendbar.

Das Gitter weist in axialer = longitudinaler Richtung (z-Richtung) eine konstante Gitterperiode $\Lambda$, eine konstante Gittergrabentiefe a und ein konstantes Tastverhältnis $W/\Lambda$ auf ($0 < W < \Lambda$), erstreckt sich jedoch in lateraler Richtung (x-Richtung) nicht über die gesamte Bauelemente-Breite, sondern weist charakteristische Begrenzungen auf. Diese Gitterbegrenzungen trennen den lateral zentral liegenden Bereich mit Gittergräben, der sich über die gesamte longitudinale Länge des optoelektronischen Bauelements erstrekken kann, von den gitterfreien Bereichen ab.

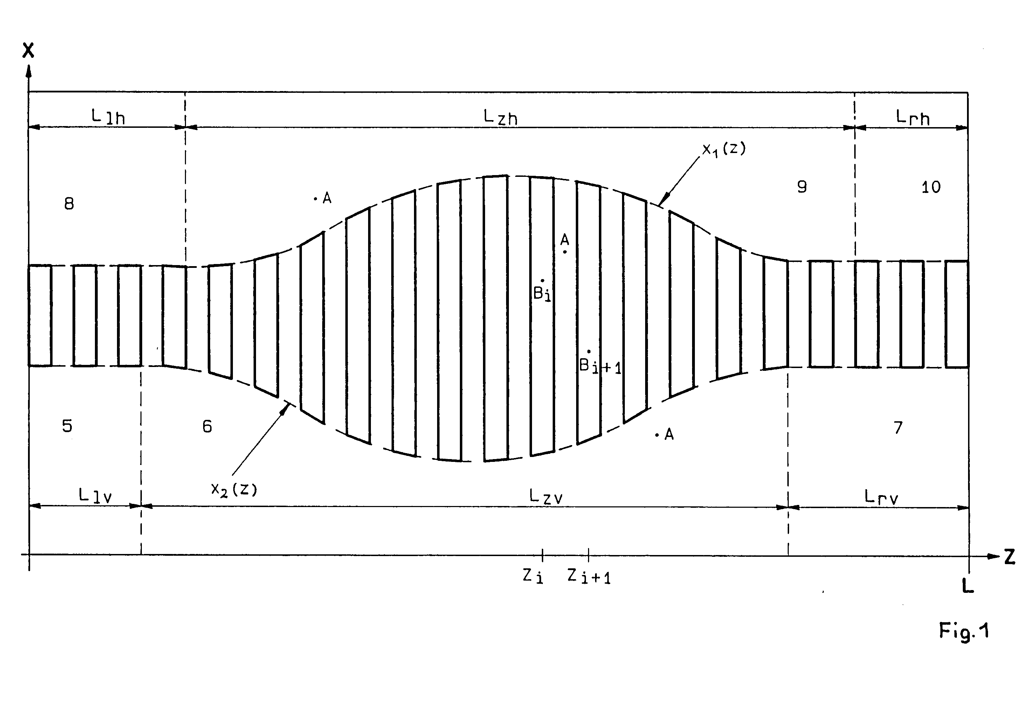

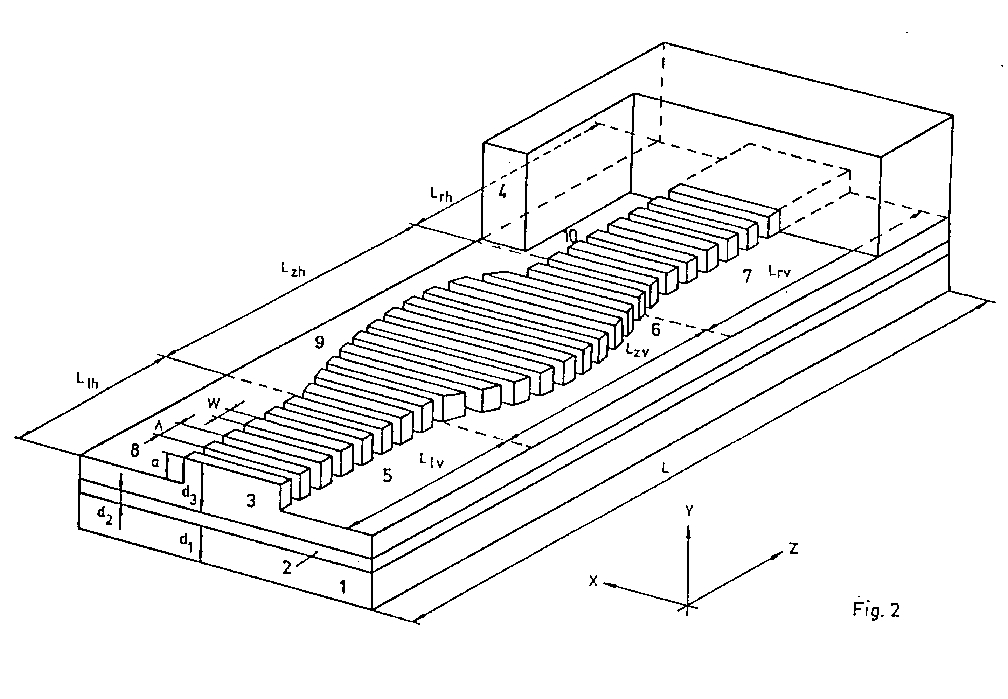

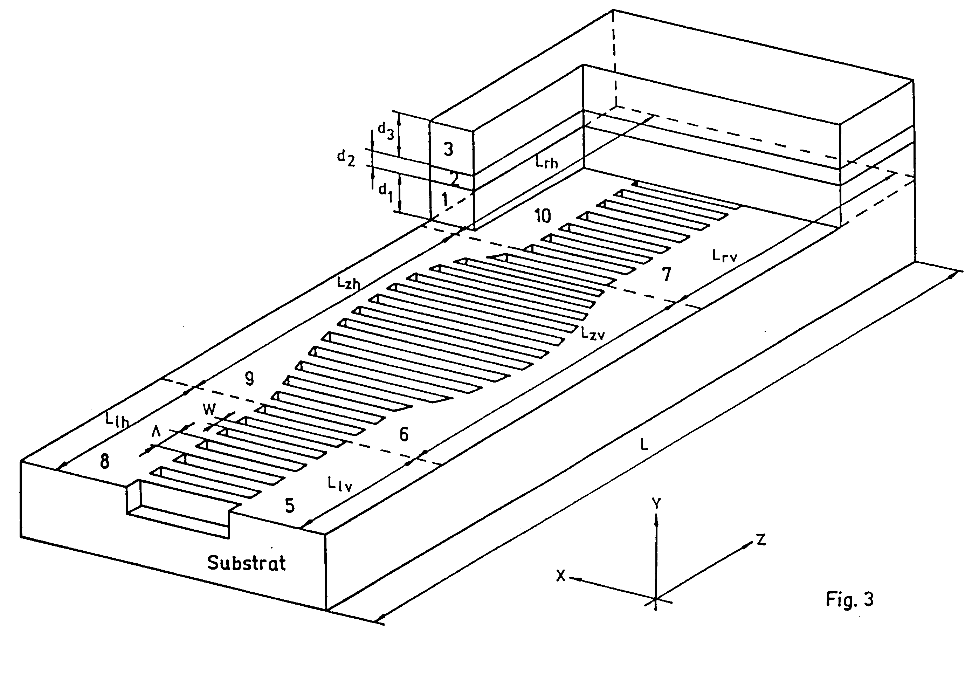

Erfindungsgemäß sind die lateral liegenden, gitterfreien Bereiche so ausgebildet, daß sie sich aus einer über die gesamte Bauelementelänge durchgehenden Folge von gitterfreien Teilbereichen 5; 6; 7 bzw. 8; 9; 10 zusammensetzen (siehe Fig. 1). Der lateral zentral liegende Gitterbereich ist bezüglich seiner lateralen Breite unterschiedlich ausgebildet, wobei der Gitterbereich, der in Zonen des optoelektronischen Bauelements angeordnet ist, in denen die Intensität des geführten Lichtfeldes deutlich von Null verschieden ist und die demzufolge in der Nähe des in den Schnitt-Ebenen senkrecht zur z-Richtung jeweils ermittelten Intensitätsmaximums des geführten Lichtfeldes liegen, Gitterbegrenzungen in Form von kontinuierlich verlaufenden Krümmungen aufweist, die durch ihre in longitudinaler Richtung quasi-kontinuierlich variierende laterale Position gekennzeichnet sind.

Je nach angestrebter Anwendung des optoelektroischen Bauelements wird mittels rechnerischer Optimierung die Bauelemente-Geometrie, die Brechungsindizes der einzelnen Halbleiter-Schichten, sowie insbesondere die mathematischen Funktionen, die den Verlauf der Gitterbegrenzungen charakterisieren, ermittelt. Durch die in longitudinaler Richtung quasi-kontinuierlich variierende laterale Breite des Bereiches mit Gittergräben, der in Zonen des optoelektronischen Bauelements angeordnet ist, in denen die Intensität des geführten Lichtfeldes deutlich von Null verschieden ist, wird eine definierte und quasi-kontinuierliche Änderung des lateralen effektiven Brechungsindex und des Kopplungskoeffizienten erreicht.

Die erfindungsgemäße Lösung wird anhand eines Ausführungsbeispiels näher erläutert:

Figur 1    zeigt eine Variation der zwei lateralen Gitterbegrenzungen $x_1(z)$ und $x_2(z)$

Figur 2    zeigt ein Beispiel für die erfindungsgemäße Ausbildung der Gitterbegrenzungen unter Verwendung einer Halbleiterstruktur mit vier Halbleiter-Schichten

Figur 3    zeigt ein Beispiel für die erfindungsgemäße Ausbildung der Gitterbegrenzungen unter Verwendung einer Halbleiterstruktur mit drei Halbleiter-Schichten

Figur 4    stellt den Verlauf des vertikalen Brechungsindex $n_{eff,y}$ als Funktion der lateralen Richtung x an zwei verschiedenen Stellen z, sowie die Positionen der auch in Fig.1 verwendeten Punkte A und B dar. Es wird der Fall gezeigt, in dem sich die laseraktive Halbleiter-Schicht über den gesamten in lateraler Richtung dargestellten Bildbereich erstreckt

In Figur 2 ist ein Beispiel für ein erfindungsgemäß ausgebildetes optoelektronisches Bauelement abgebildet, dessen Bauelementekern aus vier verschiedenen Halbleiter-Schichten 1 bis 4 besteht, welche in vertikaler Richtung, y-Richtung, übereinander auf dem Halbleitersubstrat angeordnet sind. Jede dieser Halbleiter-Schichten ist in y-Richtung nicht notwendigerweise homogen, sondern kann auch ihrerseits wieder aus verschiedenen Einzelschichten oder aus kontinuierlichen Übergängen zwischen verschiedenen Halbleiter-Schichten aufgebaut sein. Die Halbleiter-Schicht 2 enthält die aktive/n Schicht/en, d. h. die Schicht/en mit höchstem Brechungsindex.

Der Brechungsindex der Halbleiter-Schichten 3 und 1 ist jeweils kleiner als derjenige der Halbleiter-Schicht 2. Ferner ist der Brechungsindex der Halbleiter-Schicht 4 kleiner als derjenige der Halbleiter-Schicht 3. Unterhalb der Halbleiter-Schicht 1 liegt das Halbleitersubstrat, das in Fig. 2 aus Gründen der Übersichtlichkeit nicht dargestellt ist. Das vertikale Dotierungsprofil der Struktur ist nach bekannten Halbleiterlaser-Design-Prinzipien zu wählen, so daß sich der pn-Übergang in der Nähe der aktiven Halbleiter-Schicht 2 oder in der aktiven Halbleiter-Schicht 2 befindet.

Wichtigstes Merkmal der Struktur ist ein besonders angeordnetes DFB- oder DBR-Gitter, welches in longitudinaler Richtung, z-Richtung, eine konstante Gitterperiode aufweist, sich jedoch in lateraler Richtung (x-Richtung) nicht über die gesamte Bauelemente-Breite erstreckt, sondern charakteristische Gitterbegrenzungen aufweist. Die lateralen Gitterbegrenzungen $x_1(z)$ und $x_2(z)$ definieren besonders ausgebildete gitterfreie Teilbereiche 5, 6 und 7 bzw. 8, 9, 10. Dabei verlaufen $x_1(z)$ und $x_2(z)$ in Zonen des Bauelements, in denen die Lichtintensität des geführten Lichtfeldes von Null verschieden ist.

Betrachtet man in Fig. 2 die vorn liegende Frontfläche in der xy-Ebene, so liegt die Maximalintensität des geführten Lichtfeldes dieser als Beispiel herausgegriffenen Fläche in der Nähe der Grenzfläche zwischen Halbleiter-Schicht 2 und 3 unterhalb der Mitte der vorn liegenden Begrenzungslinie des Gitterbereichs. Für die Wirksamkeit des vorgeschlagenen Prinzips ist dabei sehr wichtig, daß die Begrenzungen $x_1(z)$ und $x_2(z)$ des Gitters einen genügend großen Überlapp mit dem geführten Lichtfeld aufweisen und somit nicht zu weit vom Intensitätsmaximum in den Schnittebenen senkrecht zur z-Richtung entfernt liegen dürfen. Die laterale Begrenzung des gitterfreien Teilbereichs 6 in Richtung des lateralen Bauelementezentrums wird durch die Funktion $x_2 = x_2(z)$ beschrieben. Die laterale Position der Begrenzung $x_2(z)$ variiert in longitudinaler Richtung auf einer Länge $L_{zv}$, während die Begrenzung $x_2(z)$ der gitterfreien Teilbereiche 5 und 7, über die Längen $L_{lv}$ und $L_{rv}$, jeweils parallel zur z-Richtung verläuft. Die Gesamtlänge des optoelektronischen Bauelements ist mit L bezeichnet.

Die laterale Begrenzung des gitterfreien Teilbereichs 9 in Richtung des lateralen Bauelementezentrums wird durch die Funktion $x_1(z)$ beschrieben. Die laterale Position der Begrenzung $x_1(z)$ variiert in longitudinaler Richtung auf einer Länge $L_{zh}$, während die Begrenzung $x_1(z)$ der gitterfreien Teilbereiche 8 und 10 über die Längen $L_{lh}$ und $L_{rh}$ jeweils parallel zur z-Richtung verläuft.

Die Stegbreite des Gitters ist durch W und die Tiefe der Gittergräben ist durch a angegeben. Der Bereich mit Gittergräben und die gitterfreien Bereiche werden jeweils bei der Herstellung der Gitter definiert, d. h. bei der Definition des Höhen- und Tiefenprofils der Grenzfläche zwischen der dritten und vierten Halbleiter-Schicht 3; 4. In dem Bereich mit Gittergräben bleibt entsprechend dem Tastverhältnis in longitudinaler Richtung das Halbleitermaterial beim Ätzprozeß an den Gitterstegen stehen. Die dazwischenliegenden Gittergräben werden auf die gewünschte Tiefe a geätzt. Die Tiefe der Gittergräben a variiert je nach Dimensionierung des gesamten Bauelements zwischen einem Betrag, welcher kleiner als die gesamte vertikale Schichtdicke der dritten Halbleiter-Schicht 3 ist und einem Betrag, welcher noch etwas größer als die Summe aus der vertikalen Schichtdicke der Halbleiter-Schicht 2 und der doppelten vertikalen Schichtdicke der dritten Halbleiter-Schicht $[d_2 + 2d_3]$ sein kann. Bei den lateral außen liegenden gitterfreien Teilbereichen 5; 6; 7 und 8; 9; 10 wird ebenfalls durch Ätzen ein in der xz-Ebene ganzflächiger Materialabtrag vorgenommen, der in seiner Tiefe der jeweiligen vertikalen Tiefe der Gittergräben a entspricht. Anschließend werden alle Bereiche ganzflächig mit einem Halbleiter-Material (Halbleiter-Schicht 4), das einen kleineren Brechungsindex aufweist, als derjenige der Halbleiter-Schicht 3, überwachsen.

Im Prinzip muß die aktive Zone nicht wie in Fig. 2 unterhalb der Gitterebene liegen, sondern kann, wie in Fig.3 aufgezeigt, in dem Fall, in dem drei Halbleiter-Schichten 1; 2; 3 über dem Halbleitersubstrat liegen, ebenso darüber angeordnet sein. Bei dieser Ausführungsform besteht der Kern des optoelektronischen Bauelements aus drei in vertikaler Richtung auf dem Halbleitersubstrat aufgebrachten Halbleiter-Schichten 1; 2 und 3, wobei ausgehend vom Halbleitersubstrat mit dem Gitter die zweite Halbleiter-Schicht 2 ebenfalls die Schicht/en mit dem höchsten Brechungsindex enthält. Der Brechungsindex der ersten und der dritten Halbleiter-Schicht 1 und 3 ist dabei kleiner als der Brechungsindex der zweiten Halbleiter-Schicht 2. Das vertikale Dotierungsprofil der Struktur ist ebenfalls nach bekannten Halbleiterlaser-Design-Prinzipien ausgestaltet, so daß sich der pn-Übergang in der Nähe oder in der aktiven zweiten Halbleiter-Schicht 2 befindet. Dabei ist sowohl n-leitendes als auch p-leitendes Halbleitersubstrat anwendbar. Der Gitterbereich weist auch in diesem Fall kontinuierlich gekrümmt verlaufende Gitterbegrenzungen $x_1(z)$ und $x_2(z)$ auf. Die laterale Breite des Gitterbereichs ist durch $[x_1(z) - x_2(z)]$ gegeben und variiert in longitudinaler Richtung. In diesem Fall wird die Festlegung der einzelnen Bereiche bei der Definition des Höhen- und Tiefenprofils der Grenzflächen zwischen dem Halbleitersubstrat und der ersten Halbleiter-Schicht 1 vorgenommen. In dem Gitterbereich bleibt beim Ätzprozeß entsprechend dem Tastverhältnis in longitudinaler Richtung das Halbleitermaterial an den Gitterstegen stehen. Die dazwischen liegenden Gittergräben werden auf die gewünschte Tiefe a geätzt. Die Tiefe der Gittergräben a kann dabei zwischen Null und $[d1 + d2\}$ variieren. Die lateral außen liegenden gitterfreien Bereiche bleiben während des Ätzprozesses vollständig erhalten, d. h., sie werden nicht abgeätzt. Im Anschluß daran werden alle Bereiche ganzflächig mit einem Halbleitermaterial (Halbleiter-Schicht 1) mit größeren Brechungsindex als der des Halbleitersubstrates überwachsen. Dabei muß ein planarisierendes Epitaxieverfahren angewendet werden. Dabei überträgt sich das in das Halbleitersubstrat geätzte Höhen- und Tiefenprofil überhaupt nicht oder nicht in voller Stärke auf die nachgeordneten Halbleiter-Schichten 1, 2 und 3. Das bedeutet, daß die Grenzflächen zwischen den Halbleiter-Schichten 1 und 2 bzw. 2 und 3 nicht dasselbe Profil aufweisen, wie die Grenzflächen zwischen dem Halbleitersubstrat und der ersten Halbleiter-Schicht 1, sondern in der xz-Ebene geglättet oder idealerweise nahezu eben verlaufen.

Entscheidend für das vorgeschlagene Bauelement ist die mathematische Form der Krümmungskurven der Gitterbegrenzungen $x_1(z)$ und $x_2(z)$. Durch die quasi-kontinuierlich in longitudinaler Richtung variierende laterale Breite $[x_1(z) - x_2(z)]$ des Gitterbereichs wird eine definierte und quasi-kontinuierliche Änderung des effektiven Brechungsindex und des Kopplungskoeffizienten erreicht. Durch entsprechende Wahl der Form der Gitterbegrenzungen $x_1 = x_1(z)$ und $x_2 = x_2(z)$ können verschiedenartigste Verteilungen des effektiven Brechungsindex in longitudinaler Richtung, z-Richtung, erreicht werden. Die gitterfreien Teilbereiche 5;7;8 und 10 mit den Teillängen $L_{lv}$, $L_{rv}$, $L_{lh}$ und $L_{rh}$, deren lateral zentrale Begrenzung $x_2(z)$ bzw. $x_1(z)$ parallel zur z-Richtung verläuft, können im Grenzfall auch die Länge Null haben, bzw. auch in der Mitte des Bauelements der Gesamtlänge L liegen. Die beiden Krümmungen der Gitterbegrenzungen $x_1 = x_1(z)$ und $x_2 = x_2(z)$ sind nicht notwendigerweise spiegelbildlich zueinander ausgebildet. Die Differenz des lateralen Abstands x der Gitterbegrenzungen $[x_1(z) - x_2(z)]$ kann im Prinzip an jeder beliebigen Stelle in longitudinaler Richtung z ihren Minimalwert annehmen. Eine Verbreiterung des Bereichs mit Gittergräben in seinem mittleren Bereich führt ebenso wirkungsvoll zu einer definierten Phasenverschiebung und einer Variation des Kopplungskoeffizienten, siehe Fig. 1; 2 und 3, wie eine entsprechende Verjüngung des Bereichs mit Gittergräben. Je nach angestrebter Anwendung des optoelektronischen Bauelements muß eine rechnerische Optimierung der Bauelemente-Geometrie, der Brechungsindex-Werte, sowie insbesondere der mathematischen Funktionen der Gitterbegrenzungen $x_1 = x_1(z)$ und $x_2 = x_2(z)$ durchgeführt werden.

In Figur 1 bis 3 werden jeweils wichtige Teile eines optoelektronischen Bauelements mit DFB-Gitter dargestellt. Es ist jedoch auch die Verwendung von DBR-Gittern möglich, in denen es in longitudinaler Richtung ebenfalls völlig gitterfreie Bereiche gibt. Die laseraktive Halbleiter-Schicht 2 muß sich nicht zwangsläufig in lateraler Richtung x über die gesamte Bauelemente-Fläche erstrecken. Sie muß jedoch in jedem Fall unter bzw. über dem zentralen Gitterbereich liegen. Die Strominjektion in die aktive Halbleiter-Schicht wird lateral gesehen auf jene Teile der laseraktiven Schicht begrenzt, welche nahe dem Maximum des geführten Lichtes liegen. Elektrisch gepumpt wird somit nur ein Streifen mit einer Länge von etwa L und einer lateralen Breite, die von vergleichbarer Größe oder etwas größer wie das Maximum von $[x_1(z) - x_2(z)]$ ist, welches im Bereich $0 < z < L$ liegt. Die laterale Ausführung der laseraktiven Schicht, sowie die Ermöglichung der Strominjektion kann nach bekannten Bauelemente-Design Prinzipien erfolgen, z. B. in Form einer vergrabenen Laserstruktur (buried hetero-structure) oder einer Rippenstruktur (ridge structure).

Die zahlenmäßige Größe des Kopplungskoeffizienten K wird vor allem bestimmt durch die Tiefe der Gittergräben a, den lokalen lateralen Abstand der Gitterbegrenzungen $[x_1(z) - x_2(z)]$ voneinander, sowie

durch das Tastverhältnis W/Λ und in geringerem Maße auch durch den präzisen Verlauf von $x_1(z)$ und $x_2(z)$. Der lokale Kopplungskoeffizient ergibt sich rechnerisch aus dem lokalen Überlapp der Gitterbereiche mit der Lichtintensitäts-Verteilung in den xy-Schnittebenen an den Stellen $z_i$ im Bauelement. Die Wellenführung (Intensitätsverteilung des geführten Lichtes in der xy-Ebene) wird durch Lösung der Maxwellschen Gleichungen mit Randbedingungen für die Zentralwellenlänge des Bauelements ermittelt. Die Zentralwellenlänge ist z. B. die angestrebte Bragg-Wellenlänge eines Ein-Sektions-DFB-Lasers oder z. B. die Wellenlänge, um die herum in einem Mehr-Sektions-Bauelement eine Wellenlängenabstimmung erfolgen soll. Die Wellenführung in der xy-Ebene wird durch die Brechungsindex-Variation in dieser Ebene festgelegt. Die vertikalen Dicken und die Brechungsindizes der einzelnen Halbleiter-Schichten werden so gewählt, daß bei einer Zentralwellenlänge eine gute Wellenführung erreicht wird, unter Berücksichtigung der lateralen Dimensionen der einzelnen Halbleiter-Schichten und deren lateralen Brechungsindex-Variationen, die insbesondere auch durch $x_1(z)$ und $x_2(z)$ gegeben ist.

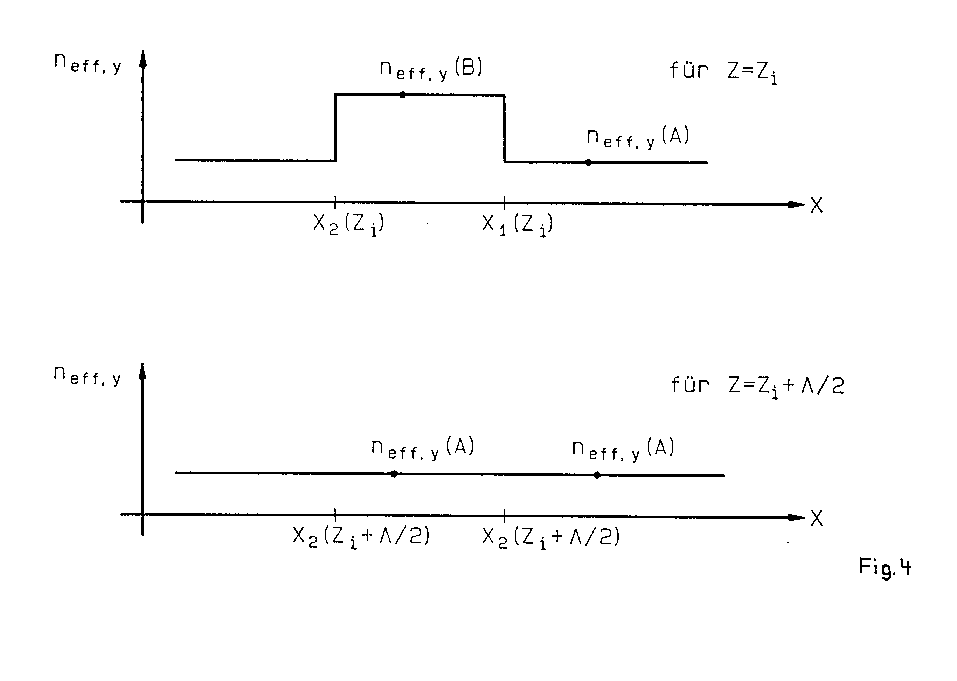

Die Berechnung des Betrags der Phasenverschiebung aus dem mathematischen Verlauf von $x_1(z)$ und $x_2(z)$ läßt sich über verschiedene Methoden realisieren. Eine mögliche Methode stellt eine Näherungslösung dar, die durch das sequenzielle rechnerische Lösen mehrerer eindimensionaler Wellengleichungs-Probleme charakterisiert ist. Dazu notwendige Arbeitsschritte werden an Fig. 1 und 4, sowie an den Ausführungsbeispielen in Fig. 2 und 3 erläutert:

1. Berechnung der Wellenführung in y-Richtung für die Zentral-Wellenlänge [siehe z. B. S. Hansmann, J. Ligthwave Technol. 10, 620 (1992)]:

a) Für eine bestimmte Gittergrabentiefe a an einer Stelle A innerhalb des Bereichs mit Gittergräben (siehe Fig.1)

Im Ausführungsbeispiel in Fig. 3 liegt an dieser Stelle A ein Gittersteg, d. h., es ist an dieser Stelle A bei der Strukturierung der Halbleiter-Grenzfläche, welche das Gitter enthält, kein Materialabtrag erfolgt. Im Ausführungsbeispiel in Fig. 2 existiert an den Punkten A ein Gittergraben, d. h., es ist an den Stellen A ein Materialabtrag bei der Definition der Halbleiter-Grenzfläche, welche das Gitter enthält, erfolgt. In die Rechnung gehen die einzelnen Schichtdicken in y-Richtung und die entsprechenden Brechungs-indizes ein.

Aus der Rechnung resultiert ein effektiver vertikaler Brechungsindex $n_{eff,y}(A)$. An allen Punkten A liegt derselbe vertikale effektive Brechungsindex vor, wenn sich die aktive Halbleiter-Schicht 2, wie in Fig. 2 und 3 dargestellt, über die gesamte in den Abbildungen gezeigte laterale Breite erstreckt.

b) Für eine bestimmte Gittergraben-Tiefe a an einer Stelle B im lateral zentralen Bereich mit Gitter. An diesen Punkten existiert im Ausführungsbeispiel in Fig. 3 ein Gittergraben und im Ausführungsbeispiel in Fig. 2 ein Gittersteg. Es resultiert daraus an allen Stellen $B_i$ im Gitterbereich derselbe effektive Brechungsindex $n_{eff,y}(B)$ in y- Richtung, wenn sich die aktive Halbleiter-Schicht 2, wie in Fig. 2 und 3 dargestellt, über die gesamte in den Abbildungen dargestellte laterale Breite erstreckt.

c) An einer Stelle A, welche lateral außerhalb des Bereichs Gittergräben liegt [$x > x_1(z)$ oder $x < x_2(z)$]. Im Ausführungsbeispiel in Fig. 2 liegt an diesen Punkten A die Grenzfläche zwischen der dritten und der vierten Halbleiterschicht 3; 4 überall in der xz-Ebene um den Betrag der Gittertiefe a tiefer als im lateral zentral liegenden gitterfreien Bereich. Im Ausführungsbeispiel in Fig. 3 ist an diesen Punk-ten A an der Halbleitergrenzfläche, in welcher das Gitter liegt, kein Materialabtrag im Halbleiter-Sub-strat durch Ätzen erfolgt.

2. Berechnung der Wellenführung in x-Richtung für die Zentral-Wellenlänge an allen Stellen $B_1...B_i...B_p$, unter Berücksichtigung der Ergebnisse von Punkt 1. Dabei ist p die Gesamtzahl der Gittergräben im Bauelement. Längs eines Schnitts durch die Stelle $B_i$ (d. h. für $z = z_i$), beträgt der Brechungsindex, wie in Fig. 4 abgebildet, in x-Richtung:

$= n_{eff,y}(A)$ für $x \geq x_1(z_i)$
$= n_{eff,y}(B)$ für $x_1(z_i) > x > x_2(z_i)$
$= n_{eff,y}(A)$ für $x_2(z_i) \geq x$

Längs eines Schnitts bei $z = z_i + Λ/2$ verläuft der Brechungsindex, wie in Fig. 4 unten abgebildet, in x-Richtung:

$= n_{eff,y}(A)$ für alle x

In die Rechnung geht entscheidend die Breite [$x_1(z) - x_2(z)$] der zentralen Schicht ein, welche den Brechungs index $n_{eff,y}(B)$ aufweist. Aus der Rechnung resultiert im Prinzip an jeder Stelle $z_i$ ein unterschiedlicher Brechungsindex $n_{eff,xy}(z_i,a)$. Durch die quasi-kontinuierlichen Funktionen $x_1 = x_1(z_i)$

und $x_2 = x_2(z_i)$ ergibt sich somit eine quasi-kontinuierliche axiale Änderung des Brechungsindex $n_{eff,xy}$-$(z_i,a)$.

Eine weitere Methode der Berechnung des Betrags der Phasenverschiebung aus dem mathematischen Verlauf $x_1(z)$ und $x_2(z)$ beruht auf einem effektiv zweidimensionalen Wellengleichungsmodell an allen Punkten $B_i$. In die Rechnung geht der Brechungsindex-Verlauf in allen xy-Ebenen ein, welche durch die Punkte $B_i$ gehen und als Normale die z-Achse besitzen. Die rechnerische Lösung dieses Problems ist wesentlich komplizierter, führt jedoch unmittelbar zu den Werten $n'_{eff,xy}(z_i,a)$. Diese Rechnung wird an allen Punkten $B_1...B_i...B_p$ durchgeführt.

Die Ergebnisse des ersten Verfahrens stellen eine Näherungslösung der präziseren Ergebnisse des zweiten Verfahrens dar. Im Folgenden wird zwischen $n'_{eff,xy}(z_i,a)$ und $n_{eff,xy}(z_i,a)$ nicht unterschieden.

Für die Definition der Phasenverschiebung gibt es zwei Möglichkeiten: erstens, der Bezug auf eine Vergleichsphase, welche für feste Werte von a, sowie festgehaltene Funktionen $x_1(z)$und $x_2(z)$ mit dem minimalen Wert $n_{eff,xy}(z_i) = n_{eff,mi}$ mathematisch verknüpft ist oder zweitens, der Bezug auf eine Vergleichsphase, welche mit dem maximalen Wert $n_{eff,xy}(z_i) = n_{eff,ma}$ mathematisch zusammenhängt. Dabei ist $n_{eff,ma}$ der maximale und $n_{eff,mi}$ der minimale Wert von allen $n_{eff,xy}(z_i)$, welche in longitudinaler Richtung an den Punkten $z_i$ vorkommen. Mögliche Werte i sind ganzzahlig und liegen im Bereich $1 \leq i \leq p$. Im folgenden steht $n_{eff,m}$ für $n_{eff,ma}$ oder $n_{eff,mi}$. Die Phasenverschiebung $\Delta\phi_w$, welche an der Stelle $z_i$ innerhalb einer Gitterperiode erzeugt wird, gegenüber einer mit $n_{eff,m}$ verknüpften Gitterperiode, errechnet sich nach

$$\Delta\varphi_W = \pi - \left( \frac{W}{\Lambda} \frac{n_{eff,xy}(z_i)}{n_{eff,m}} - 1 \right) \qquad (1)$$

Die gesamte Phasenverschiebung des Gitters ergibt sich aus der Summe der Phasenverschiebungsanteile jeder einzelnen Gitterperiode.

$$\Delta\varphi = \sum_{i=1}^{p} \pi - \left( \frac{W}{\Lambda} \frac{n_{eff,xy}(z_i)}{n_{eff,m}} - 1 \right) \qquad (2)$$

Der Abstand $[x_1(z)-x_2(z)]$ kann zwischen $0,1\mu m$ und $5\mu m$, je nach Anforderung an das Bauelement, durch entsprechende Wahl der Funktionen $x_1(z)$ und $x_2(z)$ gewählt werden. Falls bei dem Bauelement laterale Einmodigkeit bei der Zentralwellenlänge erwünscht ist, muß bei der Dimensionierung auf einen genügend großen Unterschied bezüglich des "optical confinement" zwischen der lateralen Grundmode und der nächst höheren lateralen Mode geachtet werden. Je weniger die Differenz $[x_1(z) - x_2(z)]$ in longitudinaler Richtung variiert wird, um so größer muß für eine festgehaltene Phasenverschiebung die Tiefe der Gittergräben a gewählt werden. Beispiel: Zur Realisierung z. B. einer $\lambda/4$ Phasenverschiebung sorgt man durch Wahl der Funktionen $x_1 = x_1(z); x_2 = x_2(z)$, sowie der Brechungsindizes und der vertikalen Dicken der einzelnen Schichten dafür, daß $\Delta\phi = \pi/2$ wird.

Die Tiefe der Gittergräben a und die lokale Differenz $[x_1(z) - x_2(z)]$ bestimmen überwiegend die lokale Größe des Kopplungskoeffizienten K an der Stelle z. Der Kopplungskoeffizient hängt ferner ab von dem Tastverhältnis $W/\Lambda$, den Funktionen $x_1 = x_1(z); x_2 = x_2(z)$ und dem detaillierten vertikalen Schichtaufbau (Dicke der einzelnen Halbleiter-Schichtpakete und deren Brechungsindizes). Je kleiner die Differenz der Gitterbegrenzungen $[x_1(z) - x_2(z)]$ und je tiefer die Gittergräben, um so größer ist jeweils der Kopplungskoeffizient K.

Die laterale Wellenführung wird durch die vorgeschlagene Struktur, insbesondere des Höhen- und Tiefenprofils der Grenzfläche, in welcher das Gitter liegt, automatisch unterstützt und herbeigeführt (siehe Fig. 2 und 3). Die laterale Wellenführung ist dabei um so größer, je größer der Brechungsindex-Unterschied auf beiden Seiten des Gitters ist. Ferner hängt die laterale Wellenführung stark von der lateralen Position der Gitterbegrenzungen $x_1(z)$ und $x_2(z)$ ab. Da bei dem vorgeschlagenen optoelektronischen Bauelement das

EP 0 632 298 A2

Gitter selbst zur lateralen Wellenleitung beiträgt, ist bei einer Ausführung des Bauelements als "ridge Struktur" (Rippen-Struktur) die Dimensionierung des Abstandes des Gitters vom vertikalen unteren Ende der Rippe wesentlich unkritischer, was die Technologie wesentlich erleichtert. Insbesondere kann der eben erwähnte Abstand durch die erfindungsgemäße Lösung größer gewählt werden und die vertikale Höhe der Rippe kleiner dimensioniert werden. Die Rippe verläuft dabei typischerweise über die gesamte longitudinale Bauelementelänge L und ist in der lateralen Breite vergleichbar oder etwas größer als der Maximalwert von $[x_1(z) - x_2(z)]$, welcher im Bereich $0 \leq z \leq L$ vorkommt. Lateral gesehen verläuft die Rippe oberhalb des lateral zentral liegenden gitterfreien Bereichs.

Die erfindungsgemäße Lösung ermöglicht eine kontinuierliche Verteilung der Phasenverschiebung eines DFB-Gitters (z. B. Verteilung einer $\lambda/4$-Phasenverschiebung über beispielsweise $L_z = 300\mu$m bei einer Bauelementelänge von $L = 600\mu$m). Dadurch wird die starke Photonenzahl-Überhöhung am Ort einer abrupten Phasenverschiebung und damit deren negative Auswirkungen auf gewisse Bauelemente-Kenngrößen vermieden.

Die in der axialen Variation des effektiven Brechungsindex $n_{eff,xy}(z_i,a)$ enthaltenen Parameter (insbesondere $x_1(z)$, $x_2(z)$, a, $W/\Lambda$, die einzelnen Schichtdicken, deren laterale Ausdehnungen und deren Brechungsindizes), können optimiert werden, um Kenngrößen des optoelektronischen Bauelements zu verbessern. Erzielt werden können für einen Halbleiterlaser beispielsweise gleichzeitig einer oder mehrere der folgenden Vorteile:

- kleinere spektrale Linienbreiten der optischen Emission
- reduziertes räumliches Lochbrennen und damit Verbesserung der longitudinalen Einmoden-Stabilität
- bessere Hochfrequenzeigenschaften, wie reduzierter Frequenz-Chirp und höhere Grenzfrequenzen unter hochfrequenter Modulation
- stabilere longitudinale Einwelligkeit bei hoher Ausgangsleistung
- mögliche Schwellenstrom-Erniedrigung der Hauptmode und mögliche Schwellenstrom-Erhöhung der Seitenmoden.

Weiterhin wird mittels der erfindungsgemäßen Lösung eine äußerst präzise Einstellung des Betrags der Phasenverschiebung, sowie der Verteilung der Phasenverschiebung in longitudinaler Richtung erreicht.

Der effektive Brechungsindex kann im Bereich der Bauelemente-Teillänge, welche die Phasenverschiebung enthält, nach nahezu beliebigen mathematischen Funktionen variiert werden. Die mathematischen Funktionen definieren dabei die Form der Gitter-Begrenzungen in der Nähe des Intensitäts-Maximums der optisch geführten Lichtwelle.

**Patentansprüche**

1. Auf DFB oder DBR-Gitter basierendes optoelektronisches Bauelement mit quasi-kontinuierlich axial verteilbarer Brechungsindex-Variation, mit axial beliebig verteilbarer und variierbarer Phasenverschiebung, sowie mit axial quasi-kontinuierlich variierbarem Gitter-Kopplungskoeffizienten, dessen Bauelementekern aus dem Halbleitersubstrat und aus mindestens drei in vertikaler Richtung übereinander angeordneten Halbleiter-Schichten besteht, daß die zweite Halbleiter-Schicht die aktive/n Schicht-/en und den innerhalb der Schichtenfolge höchsten Brechungsindex aufweist, daß das Gitter entweder über oder unter der zweiten Halbleiter-Schicht angeordnet ist, daß die optische Rückkopplung des geführten Lichtes dadurch entsteht, daß eine oder mehrere Halbleiter-Schichten derart strukturiert sind, daß eine periodische Variation des Real- und/oder Imaginärteils des Brechungsindexes in axialer Bauelementerichtung existiert, und daß sich das Gitter nicht über die gesamte laterale Bauelementebreite erstreckt, sondern nur über einen lateral zentral liegenden Bereich, der in axialer Richtung über die gesamte Bauelementelänge jeweils eine konstante Gitterperiode, ein konstantes Tastverhältnis und eine konstante Gittergraben-Tiefe aufweist, **dadurch gekennzeichnet**, daß der lateral zentral liegende Gitterbereich aus einer in longitudinaler Richtung durchgehenden Folge von Gitterbereichen besteht, die in longitudinaler Richtung variierend unterschiedliche laterale Breiten aufweisen, daß die Gitterbereiche, die in Zonen des optoelektronischen Bauelements angeordnet sind, in denen die Intensität des geführten Lichtes deutlich von Null verschieden ist und die in der Nähe des in den Schnitt-Ebenen senkrecht zur z-Richtung jeweils ermittelten Intensitätsmaximums des geführten Lichtes liegen, Gitterbegrenzungen zu den Bereichen ohne Gittergräben aufweisen, die in Form von Krümmungen mit quasi-kontinuierlich in longitudinaler Richtung variierender lateraler Position ausgebildet sind, daß die konkrete Form der Gitterbegrenzungen und die konkrete Tiefe der Gittergräben, das Tastverhältnis, die Bauelementegeometrie und der vertikale Brechungsindexverlauf über mathematische Methoden festgelegt werden, wobei gilt, je kleiner die Differenz des lateralen Abstandes zwischen den Gitterbegrenzungen, um so kleiner der Kopplungskoeffizient, und daß die lateral links und lateral rechts

8

des gesamten Gitterbereichs liegenden gitterfreien Bereiche jeweils aus einer Folge von gitterfreien Teilbereichen bestehen, die in longitudinaler Richtung variierend, unterschiedliche laterale Breiten aufweisen.

2. Auf DFB oder DBR-Gitter basierendes optoelektronisches Bauelement nach Anspruch 1, dadurch gekennzeichnet, daß die in longitudinaler Richtung (z) durchgehend angeordneten Gitterbegrenzungen, die durch die Funktionen $x_1 = x_1(z)$ und $x_2 = x_2(z)$ definiert sind und die den gesamten Gitterbereich von den Teilbereichen ohne Gittergräben abgrenzen, in ihrer Form so ausgebildet sind, daß die lateral liegenden gitterfreien Bereiche jeweils in drei sich über die gesamte Bauelementelänge (L) erstreckende gitterfreie Teilbereiche (5; 6; 7) bzw. (8; 9; 10) unterteilt sind, daß dabei die Begrenzung $x_2(z)$ des gitterfreien Teilbereichs (5), auf ihrer gesamten Teillänge ($L_{lv}$) parallel zur z-Richtung,d.h. in longitudinaler Richtung, verläuft, daß die Begrenzung $x_2(z)$ des gitterfreien Teilbereichs (6) auf ihrer gesamten Teillänge ($L_{zv}$) einer quasi-kontinuierlich in longitudinaler Richtung variierenden lateralen Veränderung unterliegt, und daß die Begrenzung $x_2(z)$ des Gitter-Teilbereichs (7), in Analogie zum Teilbereich (5), auf ihrer gesamten Teillänge ($L_{rv}$) Parallel zur z-Richtung verläuft, daß dabei die Begrenzung $x_1(z)$ des gitterfreien Teilbereichs (8) auf ihrer gesamten Teillänge ($L_{lh}$) Parallel zur z-Richtung verläuft, daß die Begrenzung $x_1(z)$ des gitterfreien Teilbereichs (9) auf ihrer gesamten Teillänge ($L_{zh}$) einer quasi-kontinuierlich in longitudinaler Richtung variierenden lateralen Veränderung unterliegt und daß die Begrenzung $x_1(z)$ des Gitter-Teilbereichs (10) auf ihrer gesamten Teillänge ($L_{rh}$) parallel zur z-Richtung verläuft.

3. Auf DFB oder DBR-Gitter basierendes optoelektronisches Bauelement nach Anspruch 1 und 2, dadurch gekennzeichnet, daß der gitterfreie Teilbereich (6) und/oder der gitterfreie Teilbereich (9), dessen Gitterbegrenzungen, $x_1(z)$ und $x_2(z)$ kontinuierlich gekrümmt ausgebildet sind, an einem longitudinalen Ende des optoelektronischen Bauelements angeordnet sind/ist.

4. Auf DFB oder DBR-Gitter basierendes optoelektronisches Bauelement, nach Anspruch 1 und 2 dadurch gekennzeichnet, daß $L_{lv} + L_{rv} = 0$ und/oder $L_{lh} + L_{rh} = 0$ ist.

5. Auf DFB oder DBR-Gitter basierendes optoelektronisches Bauelement nach Anspruch 1 und 2, dadurch gekennzeichnet, daß die Begrenzungen $x_2(z)$ des gitterfreien Teilbereichs (6) und die Begrenzung $x_1(z)$ des gitterfreien Teilbereichs (9) jeweils parallel zur z-Richtung verlaufen und daß die restlichen Streckenabschnitte von $x_1(z)$ und $x_2(z)$ in longitudinaler Richtung jeweils gekrümmt verlaufen.

6. Auf DFB oder DBR-Gitter basierendes optoelektronisches Bauelement nach Anspruch 1 bis 5, dadurch gekennzeichnet, daß insbesondere die sich gegenüberliegenden Gitterbegrenzungen $x_1(z)$ und $x_2(z)$ bezüglich ihrer mathematischen Form völlig unterschiedlich ausgebildet sind, wobei im Extremfall eine Gitterbegrenzung gekrümmt und die der gekrümmten Gitterbegrenzung gegenüberliegende Gitterbegrenzung ungekrümmt verläuft.

7. Auf DFB oder DBR-Gitter basierendes optoelektronisches Bauelement nach Anspruch 1 bis 5, dadurch gekennzeichnet, daß das Gitter unterhalb der aktiven Halbleiter-Schicht (2) angeordnet ist.

8. Auf DFB oder DBR-Gitter basierendes optoelektronisches Bauelement nach Anspruch 1 bis 5, dadurch gekennzeichnet, daß das Gitter oberhalb der aktiven Halbleiter-Schicht 2 angeordnet ist.

9. Auf DFB oder DBR-Gitter basierendes optoelektronisches Bauelement nach Anspruch 7, dadurch gekennzeichnet, daß in dem Fall, in dem bei drei Halbleiter-Schichten (1-3) das Gitter unterhalb der zweiten Halbleiter-Schicht (2) angeordnet ist, die Tiefe der Gittergräben (a) in einem Bereich variierbar ist, welcher zwischen Null und der Summe der vertikalen Schichtdicke der ersten und der zweiten Halbleiter-Schicht (1;2) liegt.

10. Auf DFB oder DBR-Gitter basierendes optoelektronisches Bauelement nach Anspruch 8, dadurch gekennzeichnet, daß in dem Fall, in dem bei vier Halbleiter-Schichten (1-4) das Gitter oberhalb der zweiten Halbleiter-Schicht (2) angeordnet ist, die Tiefe der Gittergräben (a) in einem Bereich variierbar ist, welcher kleiner als die vertikale Schichtdicke der dritten Halbleiter-Schicht (3), aber nicht viel größer als die Summe der vertikalen Schichtdicke der zweiten Halbleiter-Schicht (2) und der doppelten vertikalen Schichtdicke der dritten Halbleiter-Schicht (3) ist.

**11.** Auf DFB oder DBR-Gitter basierendes optoelektronisches Bauelement nach Anspruch 1 bis 2, dadurch gekennzeichnet, daß in die Struktur des optoelektronischen Bauelements mindestens fünf Halbleiter-Schichten (1-5) integriert sind.

**12.** Auf DFB oder DBR-Gitter basierendes optoelektronisches Bauelement nach Anspruch 1 bis 11, dadurch gekennzeichnet, daß der über eine quadratische Fläche der parallel zu den Gitterstegen liegenden Kantenlängen 2Λ gemittelte vertikale effektive Brechungsindex der Gitterfelder größer ist als der vertikale effektive Brechungsindex in den gitterfreien Teilbereichen, wobei der Unterschied der vertikalen effektiven Brechungsindizes einerseits durch die Strukturierung der Gitterebene, d. h. durch das Höhen- und Tiefenprofil der Halbleitergrenzfläche und andererseits durch die Brechungsindizes der beiden das Gitter einschließenden Halbleiterschichten gegeben sind, wodurch die laterale Wellenführung der Lichtwelle wesentlich unterstützt wird.

**13.** Auf DFB oder DBR-Gitter basierendes optoelektronisches Bauelement nach Anspruch 1 bis 6, dadurch gekennzeichnet, daß die erste Halbleiter-Schicht (1) die aktive/n Schicht/en mit dem höchsten Brechungsindex enthält.

Fig.1

EP 0 632 298 A2

Fig. 2

Fig. 3

EP 0 632 298 A2

Fig. 4